# EUROPÄISCHE PATENTSCHRIFT

(11) **EP 1 244 341 B1**
(45) Veröffentlichungstag und Bekanntmachung des Hinweises auf die Patenterteilung: **27.09.2006**
(21) Anmeldenummer: 02005874.9
(22) Anmeldetag: 14.03.2002
(51) Int. Cl.: H05K 9/00, H05K 5/00

(54) **Elektronische Vorrichtung**
Electronic device
Dispositif électronique

(30) Priorität: 21.03.2001 DE 10113912
(43) Veröffentlichungstag der Anmeldung: 25.09.2002
(73) Patentinhaber: SIEMENS AKTIENGESELLSCHAFT, 80333 München (DE)
(72) Erfinder: Berberich, Reinhold, 60439 Frankfurt (DE)

(56) Entgegenhaltungen:
- EP-A- 1 028 497
- EP-A- 1 148 602
- DE-A1- 19 630 720
- US-A- 5 101 322

## Beschreibung

Die Erfindung betrifft eine elektronische Vorrichtung mit einem Gehäuse zur Aufnahme eines, eine elektronische Baugruppe tragenden Trägersubstrates, welches zur elektrischen Verbindung der elektronischen Baugruppe eine Leiterstruktur aufweist, wobei im Gehäuse eine Filtereinrichtung zur Verbesserung der elektromagnetischen Empfindlichkeit angeordnet ist.

Um eine einwandfreie Funktion von elektronischen Einrichtungen zu gewährleisten, ist es erforderlich, diese gegenüber Störstrahlungen, welche insbesondere im Hochfrequenzbereich auftreten, abzuschirmen. Solche Entstörmaßnahmen werden üblicherweise im Inneren des elektronischen Gerätes vorgenommen.

Aus der DE 299 02 505 U1 ist ein Planarfilter bekannt, bei welchem auf einem Keramiksubstrat ein Kondensator ausgebildet ist. Die eine Seite des keramischen Trägers ist mit der Masseelektrode und die andere Seite mit den Signalelektroden des Kondensators versehen. Die Signalelektroden bilden dabei inselförmige Bereiche, welche Stiftdurchführungen von Signalstiften umschließen. Solche Störschutz-Filter werden in elektronischen Steuergeräten im Kraftfahrzeug eingesetzt, wobei das Störschutz-Filter im Gehäuse direkt am Eingang der Steckeranschlüsse angeordnet ist.

Nachteilig dabei ist, dass bei der Montage dieses Planarfilters die gute Funktion nur gewährleistet ist, wenn eine zuverlässige elektrische und/oder kapazitive Anbindung an ein Gehäuse sichergestellt wird, um undefinierte Kapazitätswerte zu vermeiden.

Aus DE-A-19630720 ist ferner eine elektronische Vorrichtung gemäß dem Oberbegriff des Anspruchs 1 bekannt.

Der vorliegenden Erfindung liegt somit die Aufgabe zugrunde, eine elektronische Vorrichtung anzugeben, welche eine auch für die Massenproduktion geeignete, einfach zu justierende Filtereinrichtung aufweist.

Erfindungsgemäß wird die Aufgabe dadurch gelöst, dass der Teil des Trägersubstrates, welcher die Filtereinrichtung umfasst, eine Gehäuseöffnung überdeckt, durch welche eine Leitung zur Zuführung des ersten elektrischen Potentials in das Gehäuseinnere eingreift.

Die Erfindung hat den Vorteil, dass die Filtereinrichtung integraler Bestandteil des Trägersubstrates ist und mit der Herstellung der Leiterplatte vorbereitet werden kann. Bei Einbau in das Gerät müssen die Leiterflächen nur noch mit den elektrischen Potentialen verbunden werden. Die Lage des Filters ist durch die Einbaulage der Leiterplatte fest vorgegeben. Für die Montage sind keine zusätzlichen Justiermaßnahmen notwendig, wie sie bei der Verwendung von separaten Filtereinrichtungen auftreten. Dies hat den Vorteil, dass eine gewöhnliche Leiterplatte, welche mehrere übereinander liegende Leiterbahnen aufweist, selbst als Filtereinrichtung wirkt.

In einer Ausgestaltung der Erfindung ist das erste elektrische Potential eine der elektronischen Baugruppe extern zugeführte Spannung und das zweite Potential das des elektrisch leitend ausgebildeten Gehäuses.

Die Filtereinrichtung läßt sich somit einfach an der Stelle positionieren, wo erfahrungsgemäß der größte Einfall von Störstrahlungen zu erwarten ist und verhindert bei bestimmungsgemäßer Montage den Eintritt hochfrequenter Strahlung in das Innere des Gehäuses. Somit entsteht eine für die Massenfertigung besonders gut handhabbare Einrichtung.

Vorteilhafterweise bildet die erste Leiterfläche der Filtereinrichtung eine erste, die externe Leitung umschließende Kondensatorfläche und eine zweite Leiterfläche eine zweite Kondensatorfläche, welche ober- und/oder unterhalb der ersten Leiterfläche elektrisch gegen diese isoliert, angeordnet ist. Bei der Verwendung von Mehrlagenleiterplatten kann durch einfache elektrische Verknüpfung der unterschiedlich gestalteten Lagen eine Filtereinrichtung geschaffen werden, auf welcher gleichzeitig die elektronischen Bauteile angeordnet und kontaktiert sind.

Vorteilhafterweise ist die externe Leitung durch mindestens ein Steckelement einer Steckeinrichtung gebildet, welche in oder an der Öffnung des Gehäuses, diese überdeckend angeordnet ist, wobei das Steckelement durch die Öffnung hindurch in den Trägerkörper eingreifend mit der ersten Kondensatorfläche elektrisch verbunden ist.

Auf diese Art und Weise kann durch einen einzigen Einpreßvorgang zur Befestigung des Steckers gleichzeitig die elektrische Kontaktierung der Kondensatorelektrode erfolgen.

Die Verwendung einer Steckeinrichtung mit mehreren Steckelementen ermöglicht auf einfache Weise, dass für jedes Steckelement die ersten, elektrisch gegeneinander isolierten, zu verschiedenen Steckelementen gehörenden Kondensatorflächen, in einer Leiterschicht ausgebildet werden.

Eine solche Struktur läßt sich während eines Arbeitsganges bei der Herstellung der Leiterplatte einfach herstellen.

Besonders einfach läßt sich die Filtereinrichtung realisieren, wenn die zweite Leiterfläche als unstrukturierte Kontaktschicht auf der Oberfläche des Trägersubstrates ausgebildet ist, welche teilweise an den elektrisch leitenden Gehäuse anliegt. Ein Schritt zur Herstellung der elektrischen Verbindung mit der zweiten Leiterfläche entfällt. Durch diese Maßnahme wirkt das Gehäuse selbst als zweite Kondensatorplatte.

Vorteilhafterweise weist das Trägersubstrat zur Ausbildung eines weiteren Kondensators für dasselbe Steckelement zwei weitere übereinander liegende, elektrisch gegeneinander isolierte Leiterflächen auf, wobei die dritte Leiterfläche elektrisch mit dem Steckelement und die vierte Leiterfläche elektrisch mit dem Gehäusepotential verbunden ist. Durch diesen mehrschichtigen Aufbau, welcher allein durch die im Trägersubstrat vorhandenen Leiterschichten begrenzt ist, können größere Kapazitätswerte pro Steckerpin realisiert werden.

Ist in einer Ausgestaltung die vierte Leiterfläche ebenfalls als unstrukturierte Kontaktfläche ausgebildet, welche an der zweiten Außenseite des Trägerkörpers angeordnet ist, sind die annähernd übereinander liegenden unstrukturierten Kontaktflächen im Umfang jedes Steckelementes über mehrere Durchkontaktierungen elektrisch miteinander verbunden. Dadurch wird eine Art Faradayscher Käfig um das Steckelement gebildet, der in Verbindung mit dem dichten Anliegen einer Außenseite des Trägerkörpers an das vorzugsweise elektrisch leitende Gehäuse Störeinkopplungen in das Innere des Gehäuses sicher verhindert.

Die Erfindung läßt zahlreiche Ausführungsformen zu. Eine davon soll anhand der in der Zeichnung dargestellten Figuren näher erläutert werden.

Es zeigt:
- Figur 1:: Schnitt durch ein Steuergerät,
- Figur 2:: Schnitt durch die erfindungsgemäße Filtereinrichtung
- Figur 3:: Lage der Filtereinrichtung zum Stecker
- Figur 4:: Draufsicht auf eine strukturierte Kondensatorfläche

Gleiche Merkmale sind mit gleichen Bezugszeichen gekennzeichnet.

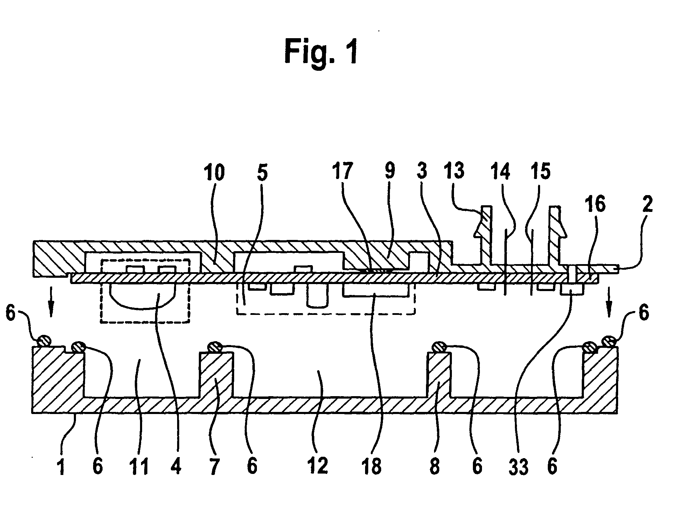

In Fig. 1 ist ein elektrisches Gerät dargestellt, wie es üblicherweise in Kraftfahrzeugen Anwendung findet. Dabei kann es sich um ein Steuergerät eines Kraftfahrzeuges handeln, welches eine signalverarbeitende Elektronik aufweist, die bekanntlicherweise sehr störanfällig gegenüber hohen Frequenzen ist. Es ist aber auch vorstellbar, dass das elektronische Gerät eine Sensoreinrichtung darstellt, welche neben dem eigentlichen Sensor eine Signalaufbereitungsschaltung und/oder eine Signalauswerteschaltung aufweist, die auf einer oder mehreren Leiterplatten angeordnet sind.

Das elektronische Gerät besitzt ein elektrisch leitfähiges, z. B. aus Aluminium bestehendes becherförmiges Gehäuseteil 1, welches mit einer ebenfalls elektrisch leitfähigen Abdeckung 2 verschlossen ist. Innerhalb des Gehäuses ist eine Mehrlagenleiterplatte 3 angeordnet, die einen Sensor 4 und eine Signalaufbereitungselektronik 5 für den Sensor 4 trägt. Die Gehäuseteile 1 und 2 sind mittels einer Leitgummidichtung 6 gegeneinander abgedichtet. Das Gehäuseteil 1 weist zwei , in das Gehäuseinnere ragende Stege 7, 8 auf, welchen gegenüberliegend zwei Stege 9, 10 der Abdeckung 2 angeordnet sind. Auf diese Weise sind zwei Schirmkammern 11, 12 gebildet, wobei der Sensor 4 in der Schirmkammer 11 und die Signalaufbereitungselektronik 5 in der Schirmkammer 12 eingreift.

Der Steg 9 der Abdeckung 2 dient gleichzeitig als Kühldom , welcher über einen Wärmeleitkleber 17 mit der Leiterplatte 3 thermisch kontaktiert ist. Auf der dem Kühldom entgegengesetzten Seite der Leiterplatte 3 ist ein Leistungsbauelement 18 der Signalaufbereitungselektronik 5 angeordnet. Die von diesem Leistungsbauelement 18 abgegebene Verlustleistung wird über den Kühldom an die Umgebung abgeführt.

An der Abdeckung 2 ist außerdem ein Stecker 13 angeordnet, dessen Steckerpins 14, 15 durch die Abdeckung 2 hindurchgreifen und in einem Endbereich 16 der Leiterplatte 3 kontaktiert sind. Die Steckerpins verbinden über die Leitebenen der Mehrlagenleiterplatte 3 die Schaltung 4 bzw. den Sensor 5 mit elektronischen Einrichtungen im Kraftfahrzeug. Sie dienen zur Zuführung von Signalen und elektrischer Leistung für die im Inneren des Gehäuses 1, 2 befindlichen Baugruppen 4 und 5.

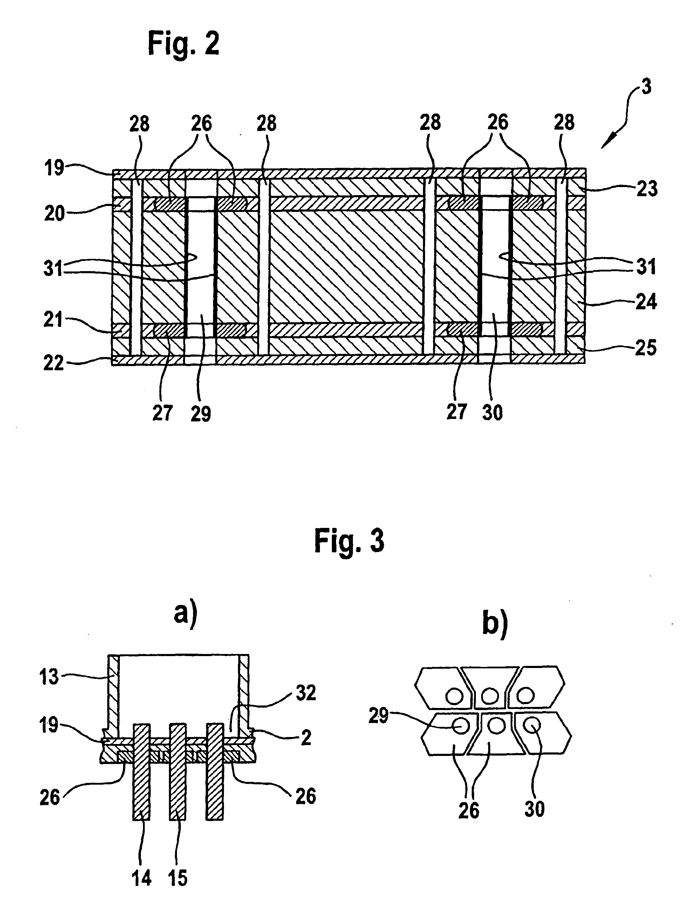

Der Teil der Leiterplatte 3, welcher als Filtereinrichtung ausgebildet ist, ist in Fig. 2 dargestellt. Die Leiterplatte 3 ist mehrschichtig ausgebildet und besteht aus miteinander verpreßten Leiterflächenschichten 19, 20, 21 bzw. 22 mit dazwischenliegenden, vorzugsweise glasgewebeverstärkten Kunstharzschichten 23, 24, 25. Es handelt sich dabei um das übliche, in der Elektronik verwendeten FR 4 ― Basismaterial. Die Darstellung in Figur 2 beschränkt sich lediglich auf die Leiterschichten, welche für die Realisierung der Filtereinrichtung notwendig sind.

Gemäß dieser Ausführung ist die Leiterplatte 3 mit vier als Kupferlagen ausgeführten Leiterflächenschichten 19, 20, 21, 22 versehen. Je eine Kupferlage 19, 22 ist auf je einer der beiden Außenseiten der Leiterplatte 3 angeordnet. Diese Lagen 19, 22 sind dabei unstrukturiert. Innerhalb der Leiterplatte befinden sich voneinander isoliert, zwei weitere Kupferlagen 20, 21, in welchen inselförmige Kondensatorflächen 26, 27 gebildet sind.

Die beiden äußeren, unstrukturierten Kupferlagen 19, 22 sind mit dem Gehäusepotential, beispielsweise Masse verbunden. Dies erfolgt, indem die Kupferlage 19 an der elektrisch leitenden Abdeckung 2 anliegt. Dabei ist die unstrukturierte Leiterfläche 19 vorzugsweise mit elektrisch leitfähigem Kleber benetzt, wodurch die Lage der Leiterplatte in diesen Bereich zuverlässig fixiert werden kann.

Alternativ kann die unstrukturierte Kupferlage 19 auch isoliert an der leitenden Abdeckung 2 anliegen und damit kapazitiv angebunden sein. Kann die elektrische Verbindung der unstrukturierten Kupferlage 22 über die Schraubverbindung 33 erfolgen. Auch Kombinationen aus den genannten Varianten sind möglich.

Die Kupferlagen 19, 22 sind über mehrere Durchkontaktierungen 28 verbunden, welche so angeordnet sind, dass sie die Kondensatorflächen 26, 27 umschließen, wodurch eine Abschirmung erreicht wird.

Die Kondensatorflächen 26, 27 umschließen jeweils eine Öffnung 29 bzw. 30 der Leiterplatte 3, in welche die Steckerpins 14 bzw. 15 eingreifen. Diese Öffnungen 29, 30 sind im Bereich 31 zwischen den Kondensatorflächen 26, 27 metallisiert, wobei jede Kondensatorfläche 26, 27 an der Grenzfläche mit der metallisierten Öffnung 29, 30 verbunden ist, wodurch eine elektrische Verbindung entsteht. Nach Einfügen des Steckerpins 14, 15 in die jeweilige Öffnung 29, 30 liegen die Kondensatorflächen 26, 27 auf Steckerpotential. Somit werden pro Steckerpin zwei Kondensatoren realisiert.

Bei dieser Ausführung sind als elektrische Verbindungsmechanismen Einpreßvorgänge für die Kontaktierung von besonderem Vorteil, wo die Steckerpins durch Einpressen in die Leiterplatte 3 kontaktiert werden. Bei dieser Ausgestaltung werden durch einen Einpreßvorgang sowohl der Stecker befestigt als auch die Kondensatorplatten elektrisch kontaktiert.

Werden noch mehr Kondensatoren benötigt, so lassen sich diese einfach durch weiteren abwechselnden Einbau von Kupferlagen, die die strukturierten Kondensatorflächen bilden und unstrukturierten, ganzflächig ausgebildeten Kupferlagen, welche auf Gehäusepotential liegen, erreichen. Bei Notwendigkeit kann eine Vielzahl solcher gegeneinander isolierter Leiterflächen innerhalb der Leiterplatte 3 angeordnet sein.

Anhand von Figur 3a soll die Lage der Filtereinrichtung, in welcher nur ein Kondensator 19, 20 dargestellt ist, zum Stecker verdeutlicht werden Die strukturierte Leiterschicht 20 weist mehrere gegeneinander isolierte Kondensatorflächen 26 auf, wie sie in Fig. 3b dargestellt sind. Zu jedem Steckerpin 14, 15 ist dabei eine Kondensatorfläche 26 vorgesehen, welche die Öffnung 29, 30 des jeweiligen Steckerpins 14, 15 umschließt. Die Leiterplatte 3 verschließt die Gehäuseöffnung dabei vollständig, wobei die unstrukturierte Kontaktschicht 19 an den Bereichen der Abdeckung 2 anliegt, welche die Gehäuseöffnung 32 umschließen.

## Patentansprüche

1. Elektronische Vorrichtung mit einem Gehäuse zur Aufnahme eines, eine elektronische Baugruppe tragenden Trägersubstrates, welches zur elektrischen Verbindung der elektronischen Baugruppe eine elektrische Leiterstruktur aufweist, wobei im Gehäuse eine Filtereinrichtung zur Verbesserung der elektromagnetischen Empfindlichkeit der elektronischen Baugruppe angeordnet ist und die Filtereinrichtung (19, 20 ; 21, 22) durch eine elektrische und/oder kapazitive Verbindung einerseits einer ersten Leiterfläche (20; 21) der Leiterstruktur mit einem externen ersten Potential und andererseits einer zweiten Leiterfläche (19; 22) der Leiterstruktur mit einem zweiten elektrischen Potential gebildet ist, wobei erste (20; 21) und zweite Leiterfläche (19; 22) annähernd gegenüberliegend angeordnet sind, **dadurch gekennzeichnet, dass** der Teil (16) des Trägersubstrates (3), welcher die Filtereinrichtung (19, 20; 21, 22) umfaßt, eine Gehäuseöffnung (32) überdeckt, durch welche eine Leitung (14, 15) zur Zuführung des ersten elektrischen Potentials in das Gehäuseinnere eingreift.

2. Elektronische Einrichtung nach Anspruch 1 **dadurch gekennzeichnet, dass** das erste elektrische Potential eine der elektronischen Baugruppe (4, 5) extern zugeführte Spannung und das zweite Potential das des elektrisch leitend ausgebildeten Gehäuses (1, 2) ist.

3. Elektronische Vorrichtung nach Anspruch 1 und 2, **dadurch gekennzeichnet, dass** aus der ersten Leiterfläche (20, 21) der Filtereinrichtung (19, 29; 21, 22) eine erste, die externe Leitung (14, 15) umschließende Kondensatorfläche (26) und aus der zweiten Leiterfläche (19, 22) eine zweite Kondensatorfläche ausgebildet ist, welche ober- und/oder unterhalb der ersten Leiterfläche (20, 21), elektrisch gegen diese isoliert, angeordnet ist.

4. Elektronische Vorrichtung nach Anspruch 3, **dadurch gekennzeichnet, dass** die externe Leitung durch mindestens ein Steckelement (14, 15) einer Steckeinrichtung (13) gebildet ist, welche in oder an der Öffnung (32) des Gehäuses (1, 2) diese überdeckend angeordnet ist, wobei das Steckelement (14, 15) durch die Öffnung (32) hindurch in den Trägerkörper (3) eingreifend mit der ersten Kondensatorfläche (26) elektrisch verbunden ist.

5. Elektronische Vorrichtung nach Anspruch 4, **dadurch gekennzeichnet, dass** die Steckeinrichtung (13) mehrere Steckelemente (14, 15) aufweist, wobei die ersten, elektrisch gegeneinander isolierten, zu verschiedenen Steckelementen gehörenden Kondensatorflächen (26) in einer Leiterfläche (20, 21) ausgebildet sind.

6. Elektronische Vorrichtung nach Anspruch 3, **dadurch gekennzeichnet, dass** die zweite Leiterfläche (19, 22) als unstrukturierte Kontaktschicht an der Oberfläche des Trägersubstrates (3) ausgebildet ist, welche zumindest teilweise an dem elektrisch leitenden Gehäuse (1, 2) anliegt.

7. Elektronische Vorrichtung nach Anspruch 3 oder 4, **dadurch gekennzeichnet, dass** das Trägersubstrat (3) zur Bildung eines weiteren Kondensators für dasselbe Steckelement (14, 15) zwei weitere übereinander liegende, elektrisch gegeneinander isolierte Leiterflächen (21, 22) aufweist, wobei die dritte Leiterfläche (21) elektrisch mit dem Steckelement (14, 15) und die vierte Leiterfläche (22) elektrisch mit dem Gehäusepotential verbunden ist.

8. Elektronische Vorrichtung nach Anspruch 7, **dadurch gekennzeichnet, dass** die unstrukturierten Kondensatorflächen (19; 22) im Umfang jedes Steckelementes über mehrere Durchkontaktierungen (28) elektrisch miteinander verbunden sind.

## Claims

1. Electronic device having a housing for accommodating a carrier substrate which is fitted with an electronic module and which has an electrical conductor structure for making electrical connection with Electronic module, a filter device for improving the electromagnetic sensitivity of Electronic module being arranged in the housing and the filter device (19, 20; 21, 22) being formed by an electrical and/or capacitive connection of a first conductor surface (20; 21) of the conductor structure to an external first potential, on the one hand, and by an electrical and/or capacitive connection of a second conductor surface (19; 22) of the conductor structure to a second electrical potential, on the other, a first conductor surface (20; 21) and second conductor surface (19; 22) being arranged approximately opposite one another, **characterized in that** the part (16) of the carrier substrate (3) which comprises the filter device (19, 20; 21, 22) covers a housing opening (32) through which a lead (14, 15) for supplying the first electrical potential to the interior of the housing engages.

2. Electronic device according to Claim 1, **characterized in that** the first electrical potential is a voltage which is supplied externally to Electronic module (4, 5), and the second potential is that of the housing (1, 2) which is embodied so as to be electrically conductive.

3. Electronic device according to Claim 1 and 2, **characterized in that** a first capacitor surface (26) which surrounds the external lead (14, 15) is formed from the first conductor surface (20, 21) of the filter device (19, 20; 21, 22), and a second capacitor surface, which is arranged above and/or below the first conductor surface (20, 21), electrically insulated therefrom, is formed from the second conductor surface (19, 22).

4. Electronic device according to Claim 3, **characterized in that** the external lead is formed by at least one plug-in element (14, 15) of a plug-in device (13) which is arranged in or on the opening (32) of the housing (1, 2) so as to cover it, the plug-in element (14, 15) being electrically connected to the first capacitor surface (26) so as to engage into the carrier element (3) through the opening (32).

5. Electronic device according to Claim 4, **characterized in that** the plug-in device (13) has a plurality of plug-in elements (14, 15), the first capacitor surfaces (26) which are electrically insulated from one another and associated with different plug-in elements being formed in a conductor surface (20, 21).

6. Electronic device according to Claim 3, **characterized in that** the second conductor surface (19, 22) is formed as an unstructured contact layer on the surface of the carrier substrate (3) which bears at least partially against the electrically conductive housing (1, 2).

7. Electronic device according to Claim 3 or 4, **characterized in that**, in order to form a further capacitor for the same plug-in element (14, 15), the carrier substrate (3) has two further conductor surfaces (21, 22) which lie one on top of the other and are electrically insulated from one another, the third conductor surface (21) being electrically connected to the plug-in element (14, 15), and the fourth conductor surface (22) being electrically connected to the housing potential.

8. Electronic device according to Claim 7, **characterized in that** the unstructured capacitor surfaces (19; 22) are electrically connected to one another within the periphery of each plug-in element by means of a plurality of vias (28).

## Revendications

1. Dispositif électronique comportant un boîtier pour recevoir un substrat porteur portant un ensemble électronique, qui présente une structure conductrice pour relier électriquement l'ensemble électronique, un dispositif de filtrage étant disposé dans le boîtier pour améliorer la sensibilité électromagnétique de l'ensemble électronique, et l'installation de filtrage (19,20;21,22) étant formée par une liaison électrique et/ou capacitive, d'un côté, d'une première surface conductrice (20; 21) de la structure conductrice avec un premier potentiel externe, et, de l'autre côté, d'une deuxième surface conductrice (19; 22) de la structure conductrice avec un deuxième potentiel électrique, la première (20; 21) et la deuxième surface conductrice (19; 22) étant disposées sensiblement en face l'une de l'autre,
**caractérisé en ce que**
la partie (16) du substrat porteur (3), qui entoure l'installation de filtrage (19,20;21,22), recouvre une ouverture (32) du boîtier par laquelle pénètre un conducteur (14; 15) pour l'arrivée du premier potentiel électrique dans l'intérieur du boîtier.

2. Installation électronique suivant la revendication 1, **caractérisée en ce que** le premier potentiel électrique est une tension appliquée extérieurement à l'ensemble électronique (4, 5), et **en ce que** le deuxième potentiel est celui du boîtier (1, 2), réalisé conducteur de l'électricité.

3. Dispositif électronique suivant la revendication 1 ou 2, **caractérisé en ce qu'**à partir de la première surface conductrice (20; 21) de l'installation de filtrage (19,20;21,22), est réalisée une première surface de condensateur (26), entourant le conducteur extérieur (14, 15), et, à partir de la deuxième surface conductrice (19,22) est réalisée une deuxième surface de condensateur, qui est disposée au-dessus et/ou au-dessous de la première surface conductrice (20; 21), en étant isolée électriquement par rapport à celle-ci.

4. Dispositif électronique suivant la revendication 3, **caractérisé en ce que** le conducteur externe est formé d'au moins un élément enfichable (14, 15) d'un dispositif d'enfichage (13), lequel est disposé dans ou contre l'ouverture (32) du boîtier (1, 2) en recouvrant celle-ci, l'élément enfichable (14, 15) étant, en traversant l'ouverture (32), en pénétrant dans le corps support (3), relié électriquement à la première surface de condensateur (26).

5. Dispositif électronique suivant la revendication 4, **caractérisé en ce que** le dispositif d'enfichage (13) présente plusieurs éléments enfichables (14, 15), les premières surfaces de condensateur (26) appartenant à différents éléments enfichables et isolées électriquement les unes des autres, étant réalisées dans une surface conductrice (20, 21).

6. Dispositif électronique suivant la revendication 3, **caractérisé en ce que** la deuxième surface conductrice (19, 22) est réalisée sous la forme d'une couche de contact non structurée contre la surface externe du substrat porteur (3), lequel est placé, au moins en partie, contre le boîtier (1, 2) conducteur de l'électricité.

7. Dispositif électronique suivant la revendication 3 ou 4, **caractérisé en ce que** le substrat porteur (3) présente pour former un autre condensateur pour le même élément enfichable (14, 15), deux autres surfaces conductrices (21, 22) placées l'une au-dessus de l'autre et isolées électriquement entre elles, la troisième surface conductrice (21) étant reliée électriquement à l'élément enfichable (14, 15) et la quatrième surface conductrice (22) étant reliée électriquement au potentiel du boîtier.

8. Dispositif électronique suivant la revendication 7, **caractérisé en ce que** les surfaces de condensateur non structurées (19; 22) à la périphérie de chaque élément enfichable sont reliées entre elles électriquement par plusieurs mises en contact (28) traversantes.
